# FASCICULE DE BREVET EUROPEEN

(11) **EP 0 521 374 B1**
(45) Date de publication et mention de la délivrance du brevet: **13.09.1995**
(21) Numéro de dépôt: 92110567.2
(22) Date de dépôt: 23.06.1992
(51) Int. Cl.: H01L 39/02, H01L 39/14, H01R 4/68

(54) **Procédé de liaison entre une céramique supraconductrice à haute température critique et un conducteur supraconducteur à base de niobium-titane**
Verfahren zur Verbindung von einem keramischen Supraleiter mit hoher kritischer Temperatur mit einem Supraleiter auf Niob-Titan Basis
Process for connecting a high critical temperature ceramic superconductor to a niobium-titanium based superconductor

(30) Priorité: 27.06.1991 FR 9107969
(43) Date de publication de la demande: 07.01.1993
(73) Titulaire: GEC ALSTHOM SA, 75116 Paris (FR)
(72) Inventeur: Février, Alain, F-78310 Maurepas (FR); Herrmann, Peter, F-91410 Corbreuse (FR); Leriche, Albert, F-91190 Gif sur Yvette (FR)
(74) Mandataire: Weinmiller, Jürgen

(56) Documents cités:
- EP-A- 0 406 862
- WO-A-89/08319
- GB-A- 2 183 110
- GB-A- 2 212 983
- PATENT ABSTRACTS OF JAPAN vol. 13, no. 218 (E-761)(3566) 22 Mai 1989 & JP-A-1 030 187
- IEEE TRANSACTIONS ON MAGNETICS. vol. 27, no. 2, Mars 1991, NEW YORK US, pages 1861-1865; J. L. WU ET AL: 'Design and testing of a high temperature superconducting current lead'
- IEEE TRANSACTIONS ON MAGNETICS. vol. 27, no. 2, Mars 1991, NEW YORK US, pages 1866-1869; F. GRIVON ET AL: 'YBaCuO current lead for liquid helium temperature applications'

## Description

La présente invention concerne un procédé de liaison mécanique et électrique entre une céramique supraconductrice à haute température critique et un conducteur supraconducteur à base de niobium-titane, destiné notamment à la réalisation des amenées de courant.

L'utilisation des supraconducteurs ou des hyperconducteurs à très basse température (par exemple à 4.2 K, température de l'hélium liquide) demande que le courant soit conduit par des amenées de courant de la zone à température ambiante (300 K) à la zone à très basse température.

En général les amenées de courant sont réalisées à l'aide de conducteurs métalliques, éventuellement refroidis par les vapeurs du fluide cryogénique.
Les besoins cryogéniques qui en résultent sont importants, et ne peuvent être réduits en-dessous d'une certaine limite, à cause du lien existant pour un métal entre les conductivités électrique et thermique (loi de Wiedemann Franz). Ainsi une amenée de courant en cuivre, fonctionnant entre 4.2 K et 300 K, optimisée pour 1000 A, dissipe 1W dans l'hélium, et utilise les vapeurs produites pour son refroidissement. La charge de refroidissement et liquéfaction de ces vapeurs est alors de l'ordre de 3 KW électriques.

Après l'apparition des céramiques supraconductrices à haute température critique (ex. : 93 K pour YBa₂ Cu₃ O_{6.9}), il a été envisagé de réaliser des amenées de courant mixtes, comprenant un supraconducteur entre la très basse température (ex : 4.2 K) et une température intermédiaire (ex : 77 K, température de l'azote liquide), complété par un conducteur métallique entre la température intermédiaire et la température ambiante.

La céramique supraconductrice présente en effet l'avantage de ne pas produire de chaleur par effet Joule en régime continu, et d'en produire très peu sous certaines conditions en régime variable. Cet avantage est associé à une faible conductivité thermique.

La publication "YBaCuO current lead for liquid helium temperature applications" - F. Grivon et al - 1990 Applied Superconductivity Conference - Snowmass Colorado - 24 à 28 septembre 1990, décrit un exemple d'amenée de courant, où l'on utilise une pièce en YBaCuO en forme de barreau ou de tube.

Par exemple, l'utilisation d'un barreau en céramique de section égale à 20 mm² et de longueur égale à 10 cm, transportant 1000A, pourrait être envisagée. Celui-ci dissiperait environ 0,2 W dans l'hélium, compensés par une consommation de 100 W électriques d'un réfrigérateur d'hélium. Il s'y ajouterait la charge de refroidissement de l'amenée de courant métallique entre 77 K et 300 K, représentant environ 400 W électriques. Une telle solution apparaît donc très avantageuse par rapport à l'amenée de courant métallique entre 4.2 K et 300 K évoquée précédemment.

Un assemblage de barreaux massifs en céramique supraconductrice HTc, a également été réalisé conformément à l'article de J.L. Wu et al et J.R. Hull et al - 1990 - Applied Superconductivity Conference - Snowmass Colorado - 24 à 28 septembre 1990.

Dans les publications précédentes, une solution a été trouvée pour réaliser un contact entre la céramique supraconductrice YBaCuO et un conducteur en cuivre. Ainsi dans l'article de F. Grivon et al, on propose d'appliquer à l'aide d'un pinceau sur la céramique YBaCuO une suspension contenant de l'argent, de sécher, et de traiter ensuite à haute température (environ 930°C). On obtient alors une résistance de contact faible, de l'ordre de 10⁻¹³Ω m². On réalise ensuite la liaison argent-cuivre.

On n'a pas résolu jusqu'à présent le problème de la liaison entre la céramique YBaCuO et un conducteur constitué de brins supraconducteurs multifilamentaires à base de niobium-titane. Il est toutefois envisageable dans ce cas de réaliser séparément une première liaison cuivre-YBaCuO et une seconde liaison cuivre-brin multifilamentaire, que l'on soude ensuite l'une à l'autre (le cuivre pouvant être remplacé par tout autre métal bien adapté). Néanmoins la présence d'une pièce intermédiaire en métal résistif entre la céramique YBaCuO et le brin supraconducteur va causer des pertes à la température de l'hélium liquide.

La présente invention a pour but de proposer un procédé de liaison permettant de réduire le plus possible les pertes, et qui demeure de mise en oeuvre simple.

La présente invention a pour objet un procédé de liaison entre une pièce en céramique supraconductrice à haute température critique et un conducteur supraconducteur à basse température critique, tel qu'un brin multifilamentaire en niobium-titane, procédé selon lequel on prépare un contact à l'argent sur ladite pièce en céramique, et caractérisé par le fait que l'on soude sur ledit contact ledit brin multifilamentaire avec un matériau de soudure intermédiaire dont la température de fusion est inférieure à 300°C ; ce matériau est choisi par exemple parmi les alliages plomb-étain, les alliages à l'argent ou au cadmium, et le métal de Wood.

Ces matériaux de soudure sont utilisés à des températures telles que le brin supraconducteur n'est pas endommagé au cours de l'opération de liaison.

Il est particulièrement avantageux de choisir le métal de Wood car il est supraconducteur à 4.2 K.

Selon une première variante de mise en oeuvre, on pratique un trou à une extrémité de la pièce en céramique, on applique dans ce trou un contact à l'argent ; on y introduit ensuite le brin multifilamentaire avec le matériau de soudure.

Si le matériau de soudure est le métal de Wood, il est intéressant de couper le brin en biais afin d'accroître la surface de contact entre la soudure et les filaments supraconducteurs du brin. La résistance du contact est alors tout à fait minimisée.

Selon une seconde variante de mise en oeuvre, on réalise le contact en argent sur un anneau de la face extérieure cylindrique ou parallélépipédique de ladite pièce en céramique, et on enroule le brin multifilamentaire tout autour de cet anneau avec ledit matériau de soudure intermédiaire.
Dans ce cas on accroît la longueur de transfert pour le courant entre la pièce et le brin et il en résulte globalement une résistance de contact plus faible. En outre, le fait d'opérer sur la surface extérieure de la pièce simplifie la procédure.

Dans les deux variantes précédentes et, surtout dans le cas où le matériau de soudure est lui-même supraconducteur, il est avantageux d'éliminer, par exemple par une méthode chimique, la matrice dans laquelle sont noyés les filaments supraconducteurs. La soudure supraconductrice est ainsi en contact direct avec les filaments, et on réalise de cette manière une liaison supraconducteur-supraconducteur. La résistance de contact peut alors atteindre des valeurs de l'ordre de 10⁻¹³Ω m².

Bien entendu, lorsque le conducteur supraconducteur comprend plusieurs brins assemblés, on applique le procédé selon l'invention à chacun des brins, quelle que soit la variante de mise en oeuvre.

D'autres caractéristiques et avantages de la présente invention apparaîtront au cours de la description suivante de modes de réalisation donnés à titre illustratif, mais nullement limitatif.

Dans le dessin annexé :
- la figure 1 est une vue partielle schématique en coupe d'une pièce en céramique avec une liaison selon l'invention,
- la figure 2 est une vue partielle schématique en élévation d'une pièce en céramique avec une variante de liaison selon l'invention.

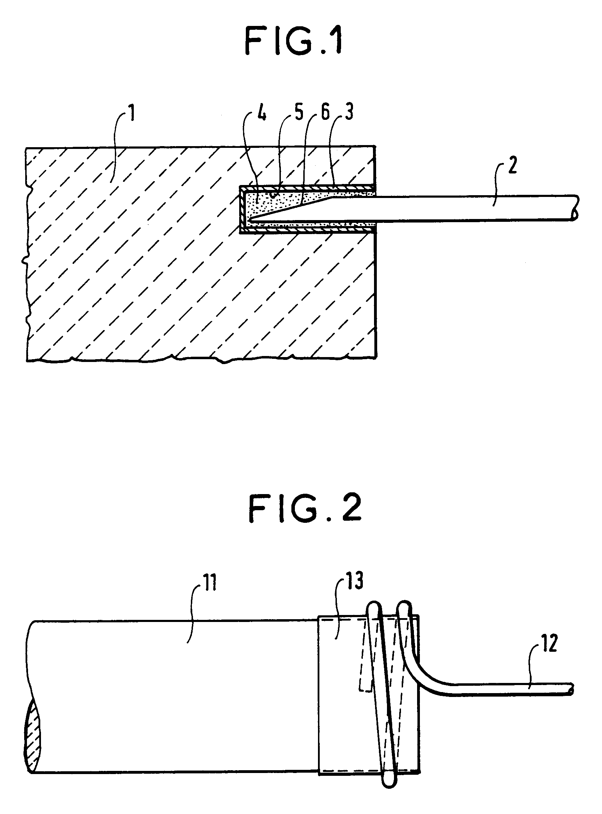

On voit dans la figure 1 l'extrémité d'une pièce en céramique supraconductrice de type YBaCuO, située dans un milieu à très basse température (4.2 K) avec un trou 5. Sur les parois de ce trou on réalise un contact 3 à l'argent, de préférence comme décrit dans la publication précitée de F. Grivon et al.

On introduit dans le trou 5 ainsi préparé un brin 2 comprenant une pluralité de filaments supraconducteurs en niobium-titane noyés dans une matrice en alliage cupro-nickel. L'extrémité 6 de ce brin a été préalablement coupée en biais. On réalise la soudure avec du métal de Wood référencé 4.

Dans la figure 2 le contact en argent 13 sur la face externe d'un barreau de céramique YBaCuO 11 a la forme d'un anneau. Le brin supraconducteur 12 est enroulé sur cet anneau et soudé par l'intermédiaire d'un matériau de soudure, tel qu'un alliage à base d'argent dont la température d'utilisation est inférieure à 300°C.

Bien entendu l'invention n'est pas limitée aux modes de réalisation qui viennent d'être décrits.

## Revendications

1. Procédé de liaison entre une pièce en céramique supraconductrice à haute température critique (1,11) et un conducteur supraconducteur à basse température critique (2), tel qu'un brin multifilamentaire en niobium-titane, procédé selon lequel on prépare un contact à l'argent (3) sur ladite pièce en céramique (1,11), et caractérisé par le fait que l'on soude sur ledit contact (3) ledit conducteur supraconducteur (2) avec un matériau de soudure intermédiaire (4) dont la température de fusion est inférieure à 300°C.

2. Procédé de liaison selon la revendication 1, caractérisé par le fait que ledit matériau de soudure intermédiaire (4) est choisi parmi les alliages plomb-étain, les alliages à l'argent ou au cadmium, et le métal de Wood.

3. Procédé de liaison selon la revendication 1, caractérisé par le fait que ledit brin (2) est introduit dans un trou (5) pratiqué dans ladite pièce en céramique.

4. Procédé de liaison selon la revendication 3, caractérisé par le fait que ledit brin est coupé en biais par rapport à son axe.

5. Procédé de liaison selon la revendication 1, caractérisé par le fait que ledit contact à l'argent est réalisé suivant un anneau (13) de la surface extérieure de la pièce (11) et que ledit brin (12) est enroulé sur ledit anneau.

## Patentansprüche

1. Verbindungsverfahren zwischen einem supraleitenden Keramikteil (1, 11) mit hoher kritischer Temperatur und einem supraleitenden Leiter (2) mit niedriger kritischer Temperatur, wie zum Beispiel einer Mehrdrahtader aus Niobium-Titan, wobei man einen Silberkontakt (3) auf dem Keramikteil (1, 11) vorbereitet, dadurch gekennzeichnet, daß man auf den Kontakt (3) den supraleitenden Leiter (2) mit einem Zwischen-Lötmaterial (4) festlötet, dessen Schmelztemperatur unter 300°C liegt.

2. Verbindungsverfahren nach Anspruch 1, dadurch gekennzeichnet, daß dieses Zwischen-Lötmaterial (4) aus den Blei-Zinn-Legierungen, den Silber- oder Kadmiumlegierungen und dem Wood-Metall ausgewählt wird.

3. Verbindungsverfahren nach Anspruch 1, dadurch gekennzeichnet, daß die Ader (2) in ein in das Keramikteil gebohrtes Loch (5) eingeführt wird.

4. Verbindungsverfahren nach Anspruch 3, dadurch gekennzeichnet, daß die Ader in Bezug auf ihre Achse schräg abgeschnitten wird.

5. Verbindungsverfahren nach Anspruch 1, dadurch gekennzeichnet, daß der Silberkontakt gemäß einem Ring (13) auf der Außenfläche des Teils (11) hergestellt wird und daß die Ader (12) auf diesen Ring gewickelt wird.

## Claims

1. A method of connecting a high critical temperature superconductive ceramic (1, 11) part and a low critical temperature superconductor (2) such as a multifilament strand of niobium-titanium, in which method a silver contact (3) is prepared on said ceramic part (1, 11), the method being characterized by the fact that said superconductor (2) is soldered to said contact (3) using an intermediate solder material (4) whose melting temperature is less than 300°C.

2. A connection method according to claim 1, characterized by the fact that said intermediate solder material (4) is selected from lead-tin alloys, alloys of silver or of cadmium, and Wood's metal.

3. A connection method according to claim 1, characterized by the fact that said strand (2) is inserted in a hole (5) formed in said ceramic part.

4. A connection method according to claim 3, characterized by the fact that said strand is cut at a slant relative to its axis.

5. A connection method according to claim 1, characterized by the fact that said silver contact is made in the form of a ring (13) on the outside surface of the part (11), and that said strand (12) is wound on said ring.
